# EUROPÄISCHE PATENTSCHRIFT

(11) **EP 0 275 940 B1**
(45) Veröffentlichungstag und Bekanntmachung des Hinweises auf die Patenterteilung: **07.04.1993**
(21) Anmeldenummer: 88100535.9
(22) Anmeldetag: 15.01.1988
(51) Int. Cl.: H03F 3/45, H03F 1/02

(54) **Differenzverstärker mit steuerbarer Leistungsaufnahme**
Differential amplifier with controllable power consumption
Amplificateur différentiel avec consommation de puissance pouvant être commandée

(30) Priorität: 22.01.1987 DE 3701791
(43) Veröffentlichungstag der Anmeldung: 27.07.1988
(73) Patentinhaber: SIEMENS AKTIENGESELLSCHAFT, 80333 München (DE)
(72) Erfinder: Hosticka, Bedrich J., Prof., D-4100 Duisburg (DE); Klinke, Roland, Dipl.-Ing., D-4600 Dortmund (DE); Pfleiderer, Hans-Jörg, Prof., D-8011 Zorneding (DE)

(56) Entgegenhaltungen:
- GB-A- 1 517 163
- US-A- 4 554 515
- DESIGN OF MOS VLSI CIRCUITS FOR TELECOMMUNICATIONS, 1985, Seiten 129-136, Verlag Prentice Hall, New Jersey, US; Y. TSIVIDIS et al.: "Exampl building blocks"
- PATENT ABSTRACTS OF JAPAN, Band 8, Nr. 88 (E-240)[1525], 21. April 1984 & JP-A-59 06 607

## Beschreibung

Die Erfindung bezieht sich auf einen Differenzverstärker mit steuerbaren Stromquellen nach den Oberbegriffen der Patentansprüche 1 oder 2.

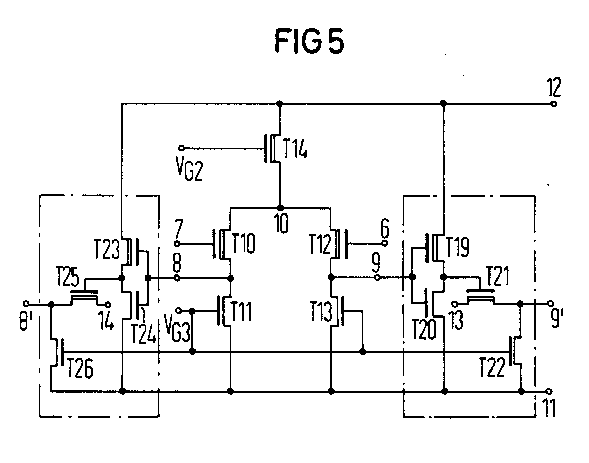

Ein Differenzverstärker dieser Art ist in dem Buch "Design of MOS VLSI Circuits for Telecommunications" von Y.Tsividis und P.Antognetti, erschienen im Verlag Prentice Hall, N.J. (1985) auf den Seiten 129 bis 136, vgl. insbesondere Fig. 5.4, beschrieben. Zwei der Stromquelle parallel geschaltete, als steuerbare Stromquellen dienende Feldeffekttransistoren werden hierbei über Stromspiegelschaltungen von den in den parallelen Spannungszweigen fließenden Strömen derart beeinflußt, daß beim Überschreiten eines festen Spannungswertes durch das einer Gatevorspannung überlagerte Eingangssignal der eine Feldeffekttransistor einen den Ruhestrom der Stromquelle verstärkenden Zusatzstrom liefert, beim Unterschreiten des festen Spannungswertes durch das überlagerte Eingangssignal der andere Feldeffekttransistor. Die Stromspiegelschaltungen sind so ausgelegt, daß der niedrige Ruhestrom durch das signalabhängige Auftreten der Zusatzströme jeweils stark vergrößert wird. Damit erreicht man gute Treibereigenschaften bei gleichzeitiger Reduzierung der Verlustleistung des Differenzverstärkers.

Ein Nachteil dieses bekannten Verstärkers besteht jedoch darin, daß insbesondere bei Zuführung eines Eingangssignals mit steil ansteigenden und abfallenden Flanken, z.B. einer Rechteckspannung, in den aus den parallelen Schaltungszweigen, den Stromspiegelschaltungen, den steuerbaren Stromquellen und dem weiteren Schaltungszweig gebildeten Regelkreisen Instabilitäten auftreten, die sehr oft zu einer Verzerrung des Ausgangssignals führen.

Aus der GB-A 1 517 163 sind Differenzverstärker bekannt, bei denen zwischen einem Schaltungsknoten und einem ersten Versorgungsspannungsanschluß zwei parallele Schaltungszweige mit jeweils einem Lastelement und einem Verstärkerelement vorgesehen sind und bei denen zwischen dem Schaltungsknoten und einem zweiten Versorgungsspannungsanschluß ein weiterer Schaltungszweig angeordnet ist, der eine Ruhestromquelle und eine dieser parallel geschaltete, steuerbare Zusatzstromquelle enthält, welche mit dem gleichgerichteten Eingangssignal des Differenzverstärkers angesteuert wird. Hierbei ist in dem Ansteuerkreis der steuerbaren Zusatzstromquelle jedoch kein pegelumsetzender Schaltungsteil vorhanden. Weitere, diesem Dokument entnehmbare Differenzverstärker weisen eine Ruhestromquelle auf, die gleichzeitig vom Eingangssignal des Differenzverstärkers ansteuerbar ist, um eine vom Eingangssignal abhängige Ruhestromkomponente zu erhalten. Hierbei sind pegelumsetzende Schaltungsteile vorgesehen, die jedoch lediglich zur Einstellung des vom Eingangssignal unabhängigen Teils des Ruhestroms dienen und nicht zu einer hiervon getrennten Einstellung der genannten Ruhestromkomponente herangezogen werden.

Der Erfindung liegt die Aufgabe zugrunde, einen Differenzverstärker der eingangs genannten Art anzugeben, der gute Treibereigenschaften aufweist, ohne daß der vorstehend genannte Nachteil in Kauf genommen werden muß. Das wird erfindungsgemäß durch eine Ausbildung des Differenzverstärkers nach den kennzeichnenden Teilen der Patentansprüche 1 oder 2 erreicht.

Der mit der Erfindung erzielbare Vorteil besteht insbesondere darin, daß gleichzeitig gute Treibereigenschaften, eine hohe Qualität der Signalübertragung und eine niedrige Verlustleistung erreicht werden.

Die Ansprüche 3 bis 5 sind auf bevorzugte Ausgestaltungen und Weiterbildungen der Erfindung gerichtet.

Die Erfindung wird nachfolgend anhand eines in der Zeichnung dargestellten, bevorzugten Ausführungsbeispiels näher erläutert. Dabei zeigt:
- Fig. 1: das Prinzipschaltbild eines erfindungsgemäßen Differenzverstärkers,
- Fig. 2: ein Spannungs-Zeit-Diagramm zur Erläuterung von Fig. 1,
- Fig. 3: eine Teilschaltung von Fig. 1,
- Fig. 4: eine Weiterbildung der Teilschaltung von Fig. 3 und
- Fig. 5: eine andere Weiterbildung der Teilschaltung von Fig. 3.

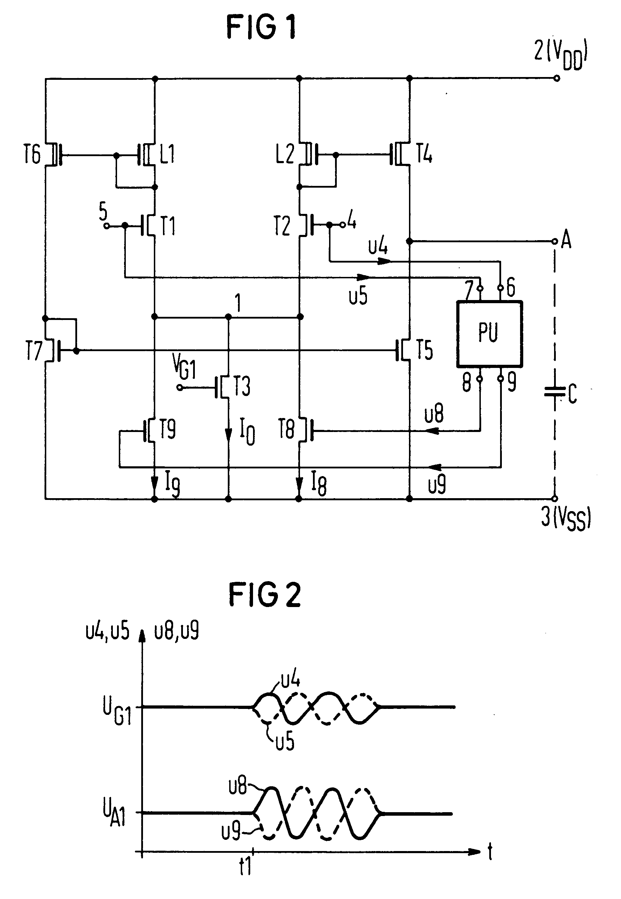

In Fig. 1 ist ein Schaltungsknoten 1 des Differenzverstärkers über zwei parallele Schaltungszweige, von denen der eine die Serienschaltung eines Lastelements L1 und eines n-Kanal-Feldeffekttransistors T1 und der andere die Serienschaltung eines Lastelements L2 und eines n-Kanal-Feldeffekttransistors T2 enthält, mit einem Anschluß 2 verbunden, der mit einer Versorgunsspannung V_{DD} beschaltet ist. Andererseits ist der Schaltungsknoten 1 über einen weiteren Schaltungszweig, der einen als Konstantstromquelle geschalteten n-Kanal-Feldeffekttransistor T3 enthält, mit einem Anschluß 3 verbunden, der auf Bezugspotential V_{SS} liegt. Dabei ist das Gate von T3 mit einer festen Gatespannung V_{G1} beschaltet. Die Lastelemente L1 und L2 bestehen aus jeweils einem p-Kanal-Feldeffekttransistor, dessen Drainanschluß mit seinem Gateanschluß verbunden ist. Zwischen den Anschlüssen 2 und 3 liegt die Serienschaltung eines p-Kanal-Feldeffekttransistors T4 und eines n-Kanal-Feldeffekttransistors T5, wobei das Gate von T4 mit dem Gate des das Lastelement L2 bildenden Feldeffekttransistors verbunden ist. Ein weiterer, die Anschlüsse 2 und 3 miteinander verbindender Schaltungszweig enthält die Serienschaltung eines p-Kanal-Feldeffekttransistors T6 und eines n-Kanal-Feldeffekttransistors T7, wobei das Gate von T6 mit dem Gate des das Lastelement L1 bildenden Feldeffekttransistors verbunden ist. Das Gate von T7 ist sowohl mit dem Drainanschluß von T7 als auch mit dem Gate von T5 beschaltet. Der Verbindungspunkt von T4 und T5 ist an den Ausgang A des Differenzverstärkers geführt, während die Gateanschlüsse 4 und 5 jeweils den positiven und den negativen Verstärkereingang darstellen.

Der positive Eingang 4 ist mit dem positiven Eingang 6 einer pegelumsetzenden Schaltung PU beschaltet, der negative Eingang 5 mit dem negativen Eingang 7 derselben. Mit 8 ist der positive Ausgang von PU bezeichnet, der mit dem Gate eines n-Kanal-Feldeffekttransistors T8 beschaltet ist, während der negative Ausgang 9 von PU mit dem Gate eines n-Kanal-Feldeffekttransistors T9 verbunden ist. T8 und T9 sind mit ihren Source-Drain-Strecken der Source-Drain-Strecke des Feldeffekttransistors T3 jeweils parallel geschaltet.

Im Betrieb wird dem Verstärkereingang 4 ein beispielsweise sinusförmiges Eingangssignal u1 zugeführt, das sich einer Vorspannung U_{G1} überlagert, so daß sich ein resultierendes Signal u4 ergibt, dessen Zeitabhängigkeit in Fig. 2 mit einer ausgezogenen Linie angedeutet ist. Am Eingang 5 liegt dann wegen der inversen Ansteuerung mit u1 ein Signal u5, das in Fig. 2 durch die Vorspannung U_{G1} und den gestrichelten Verlauf der Spannungskurve gekennzeichnet ist. Ohne das Eingangssignal u1 liegt an beiden Eingängen 4, 5 die Vorspannung U_{G1}, die so bemessen ist, daß sich T1 und T2 im leitenden Zustand befinden. Die Konstantstromquelle T3 liefert hierbei einen Ruhestrom I₀, der sich bei gleich großen Lastelementen L1, L2 gleichmäßig auf beide Schaltungszweige L1, T1 und L2, T2 aufteilt. In diesen fließt dann jeweils I₀/2. Stimmen die strukturellen Auslegungen der Transistoren L2 und T4 überein, so bilden diese einen Stromspiegel, der bewirkt, daß auch der Transistor T4 von I₀/2 durchflossen wird. In analoger Weise sorgt der aus L1 und T6 bestehende Stromspiegel bei gleicher struktureller Auslegung dieser Transistoren dafür, daß auch T6 und damit T7 von I₀/2 durchflossen werden. Der aus den gleich strukturierten Transistoren T7 und T5 bestehende Stromspiegel sorgt schließlich dafür, daß T5 ebenso wie T7 von I₀/2 durchflossen sind. Gleichgroße Ströme in den Source-Drain-Strecken von T4 und T5 bedeuten aber, daß über den Ausgang A kein Strom in einen nachgeordneten Laststromkreis fließt, der durch eine Kapazität C angedeutet wird.

Die ohne das Eingangssignal u1 auch an den Eingängen 6 und 7 der pegelumsetzenden Schaltung PU anliegende Vorspannung U_{G1} wird in PU auf einen niedrigeren Ausgangspegel U_{A1} umgesetzt, der z.B. dem Wert der Einsatzspannung der n-Kanal-Feldeffekttransistoren T8 und T9 entspricht oder diesen geringfügig unterschreitet. Im letzteren Fall ist sichergestellt, daß die Transistoren T8 und T9 bei fehlendem Eingangssignal u1 sperren, so daß der Ruhestrom I₀ nicht vergrößert wird.

Tritt zum Zeitpunkt t1 das Eingangssignal u1 auf, so ergibt sich die in Fig. 2 angedeutete sinusförmige Aussteuerung von T2 und T1 entsprechend den Spannungsverläufen u4 und u5. Durch die Wirkungsweise der pegelumsetzenden Schaltung PU werden dabei an den Ausgängen 8 und 9 Spannungen erhalten, die in Fig. 2 mit u8 und u9 bezeichnet sind. Im einzelnen entspricht u8 einem dem Gate von T8 zugeführten Vorspannungswert U_{A1} , dem das in PU verstärkte Eingangssignal u1 überlagert ist, während sich u9 aus dem Vorspannungswert U_{A1} und einem diesem überlagerten, verstärkten und invertierten Eingangssignal u1 zusammensetzt. Jede U_{A1} übersteigende Sinushalbwelle von u8 schaltet den Transistor T8 in den leitenden Zustand, so daß ein I₀ verstärkender Zusatzstrom I₈ durch T8 fließt, der sich auf die parallelen Schaltungszweige L1, T1 und L2, T2 aufteilt. Auch beim Auftreten jeder den Wert U_{A1} unterschreitenden Halbwelle von u8 tritt ein I₀ verstärkender Zusatzstrom auf, und zwar wegen der mit diesen Halbwellen zeitlich zusammenfallenden Halbwellen von u9, die ihrerseits die Vorspannung U_{A1} übersteigen. Letztere bewirken eine Leitendschaltung des Transistors T9, über den dann ein Zusatzstrom I₉ fließt. Die Zusatzströme I₈ und I₉ bewirken also eine starke Anhebung des Ruhestroms I₀ wärend des Auftretens eines Eingangssignals u1. Die Transistoren T8 und T9 stellen steuerbare Stromquellen dar, die signalabhängig angeschaltet werden, um die Ströme in den parallelen Schaltungszweigen des Differenzverstärkers und damit auch im Ausgangskreis A, C, 3 wesentlich zu erhöhen, d.h. gute Treibereigenschaften zu gewährleisten. Wenn kein Eingangssignal u1 anliegt, ist der Ruhestrom I₀ so klein, daß die Leistungsaufnahme des Verstärkers sehr gering bleibt.

Da die den eingangsseitigen Pegel U_{G1} auf den ausgangsseitigen Pegel U_{A1} umsetzende Schaltung PU von den Verstärkereingängen 4, 5 her angesteuert wird, sind keine Regelkreise wie bei dem eingangs erwähnten bekannten Differenzverstärker vorhanden, so daß das bei A auftretende Ausgangssignal, das an den Verbinddungspunkten der Transistoren L1, T1 und der Transistoren L2 und T2 abgegriffen und über die Stromspiegel L2, T4 sowie L1, T6 und T7, T5 an den Ausgang A übertragen wird, weitgehend verzerrungsfrei ist. Die Übertragung des Ausgangssignals an den Ausgang geht dabei im einzelnen so vor sich, daß sich bei jeder durch die Aussteuerung von T2 und T1 mit dem Eingangssignal u1 bewirkten Größendifferenz der durch L2 und L1 fliessenden Ströme eine entsprechende Größendifferenz der Ströme durch T4 und T5 ergibt, die zu einem an A abgreifbaren Ausgangsstrom führt. Beim Differenzverstärker nach der Erfindung spricht das Ausgangssignal sehr schnell auf Schwankungen des Eingangssignals u1 an, so daß auch Eingangssignale mit steil ansteigenden und abfallenden Flanken, z.B. Rechteckspannungen, weitgehend verzerrungsfrei und mit großer Stromerhöhung an den Ausgang A übertragen werden.

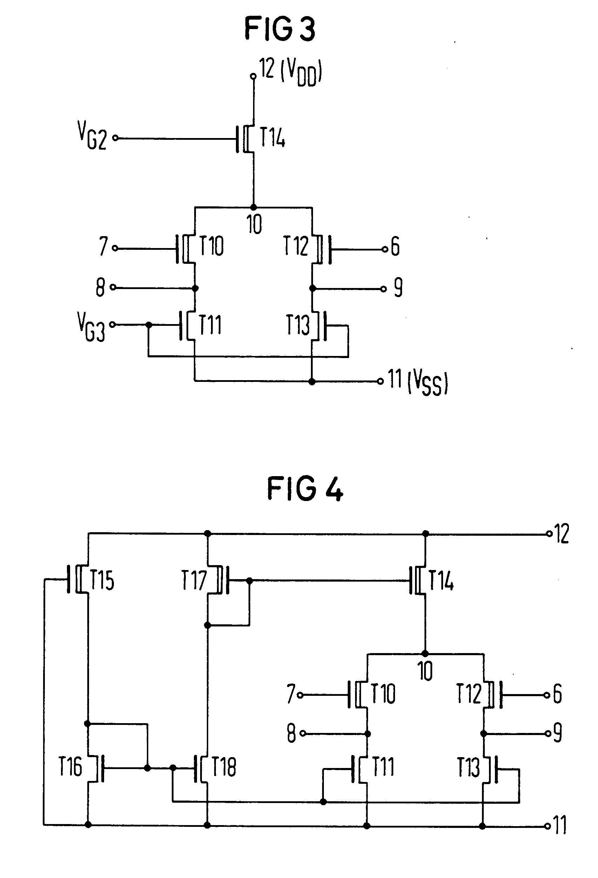

Fig. 3 zeigt ein bevorzugtes Ausführungsbeispiel der pegelumsetzenden Schaltung PU. Die als Differenzverstärkerstufe aufgebaute Schaltung enthält im einzelnen zwei zwischen einem Schaltungsknoten 10 und einem auf dem Bezugspotential V_{SS} liegenden Anschluß 11 angeordnete, parallele Stromzweige, von denen der erste einen p-Kanal-Feldeffekttransistor T10 in Serie zu einem n-Kanal-Feldeffekttransistor T11 und der zweite einen p-Kanal-Feldeffekttransistor T12 in Serie zu einem n-Kanal-Feldeffekttransistor T13 aufweisen. Der Schaltungsknoten 10 ist über einen Schaltungszweig, der die Source-Drain-Strecke eines p-Kanal-Feldeffekttransistors T14 enthält, mit einem Anschluß 12 verbunden, der mit der Versorgungsspannung V_{DD} beschaltet ist. Das Gate von T14 liegt an einer vorgegebenen Gatespannung V_{G2}, die Gates von T11 und T13 an einer vorgegebenen Gatespannung V_{G3}. Die Ein- und Ausgänge 6, 7, 8 und 9 von PU sind mit den in Fig. 1 verwendeten Bezugszeichen versehen. Die strukturellen Abmessungen der Transistoren T11 und T13 müssen untereinander gleich sein und sich von den strukturellen Abmessungen des Transistors T14 so weit unterscheiden, daß T11 und T13 im Triodengebiet, d.h. im ansteigenden Teil ihrer I_{D}/U_{DD}-Kennlinie arbeiten, während T14 in der Sättigung betrieben wird. Diese Bedingung läßt sich dadurch erfüllen, daß die Summe der Sättigungsströme von T11 und T13 größer gewählt wird als der Sättigungsstrom von T14. In einem ausgeführten Schaltungsbeispiel wurde die genannte Bedingung bei einer Versorgungsspannung V_{DD} von 10 Volt einer vorgegebenen Gatespannung V_{G2} von 8 Volt und einer vorgegebenen Gatespannung V_{G3} von 2 Volt dadurch erreicht, daß die Kanalweiten/Kanallängenverhältnisse von T11 und T13 jeweils zu 10/5 und das Kanalweiten/Kanallängenverhältnis von T14 zu 48/5 gewählt wurde.

In Fig. 4 ist eine Weiterbildung der Schaltung nach Fig. 3 dargestellt, bei der die vorgegebenen Gatespannungen V_{G2} und V_{G3} über zwei die Anschlüsse 11 und 12 miteinander verbindenden Stromzweige gewonnen werden. Der erste derselben enthält die Serienschaltung eines p-Kanal-Feldeffekttransistors T15 und eines n-Kanal-Feldeffekttransistors T16, der zweite die Serienschaltung eines p-Kanal-Feldeffekttransistors T17 und eines n-Kanal-Feldeffekttransistors T18. Dabei sind der Gateanschluß von T15 mit dem Anschluß 11 verbunden, der Gateanschluß von T16 sowohl mit dem Gateanschluß von T18 als auch mit dem Drainanschluß von T16, der Gateanschluß von T17 mit dem Drainanschluß von T17. An den Gateanschlüssen von T17 und T18 sind dann jeweils die Gatespannungen V_{G2} für T14 und V_{G3} für T11 und T13 abgreifbar. Bei einer Erweiterung des bereits genannten ausgeführten Schaltungsbeispiels nach Fig.3 durch die in Fig. 4 dargestellten zusätzlichen Stromzweige wurde für T16 und T18 jeweils ein Kanalweiten/Kanallängenverhältnis von 16/5, für T15 ein solches von 5/15 und für T17 ein dem Transistor T14 angeglichenes Kanalweiten/Kanallängenverhältnis von 48/5 gewählt.

Wie in Fig. 5 dargestellt ist, kann die Schaltung nach Fig. 3 mit Vorteil durch zwei Schaltungsteile INV1 und INV2 erweitert werden. INV1 enthält die Serienschaltung eines p-Kanal-Feldeffekttransistors T19 und eines n-Kanal-Feldeffekttransistors T20, deren Gates mit dem Ausgang 9 der Differenzverstärkerstufe nach Fig. 3 beschaltet sind. Der Verbindungspunkt von T19 und T20 ist mit dem Gate eines weiteren p-Kanal-Feldeffekttransistors T21 verbunden, dessen Sourceanschluß 13 mit der Versorgungsspannung V_{DD} beschaltet ist und dessen Drainanschluß den einen Ausgang 9ʹ der erweiterten Schaltung darstellt, der an die Stelle des Ausgangs 9 von Fig. 3 tritt. Der Drainanschluß von T21 ist über einen n-Kanal-Feldeffekttransistor T22 mit dem Anschluß 11 verbunden, wobei das Gate von T22 mit der vorgegebenen Gatespannung V_{G3} belegt ist. Analog dazu enthält INV2 die Serienschaltung eines p-Kanal-Feldeffekttransistors T23 und eines n-Kanal-Feldeffekttransistors T24, deren Gates mit dem Ausgang 8 beschaltet sind. Der Verbindungspunkt von T23 und T24 ist mit dem Gate eines p-Kanal-Feldeffekttransistors T25 beschaltet, dessen Sourceanschluß 14 mit der Versorgungsspannung V_{DD} belegt ist und dessen Drainanschluß den Ausgang 8ʹ der erweiterten Schaltung darstellt, der an die Stelle des Ausgangs 8 von Fig. 8 tritt. Der Drainanschluß von T25 ist schließlich über einen n-Kanal-Feldeffekttransistor T26, dessen Gate mit V_{G3} beschaltet ist, mit dem Anschluß 11 verbunden.

Beim Auftreten eines Ausgangssignals u8, das gemäß Fig. 2 den Wert von U_{A1} übersteigt, wird der aus T23 und T24 bestehende Inverter von einem hohen auf einen niedrigen, etwa V_{SS} entsprechenden Ausgangspegel umgeschaltet. Damit leitet T25 und führt die an 14 anliegende Versorgungsspannung praktisch vollständig über 8ʹ an das Gate von T8. Andererseits wird beim Auftreten eines Ausgangssignals u8, das den Wert von U_{A1} unterschreitet, durch das hierbei gleichzeitig auftretende Signal u9 der aus T19 und T20 bestehende Inverter ebenfalls auf einen niedrigen Ausgangspegel umgeschaltet, was dazu führt, daß über den leitend geschalteten T21 die bei 13 anliegende Versorgungsspannung praktisch vollständig zur Aussteuerung des über 9ʹ erreichbaren Transistors T9 herangezogen wird. Die Aussteuerung von T8 und T9 erfolgt bei gleichem Eingangssignal u1 durch die Funktion der Schaltungsteile INV1 und INV2 wesentlich schneller als bei der Schaltung nach Fig. 3.

In Abweichung von den bisher beschriebenen Ausführungsformen der Erfindung kann der von der pegelumsetzenden Schaltung PU abgegebene Pegelwert U_{A1} (Fig. 2) auch größer oder kleiner gewählt werden als die Einsatzspannung von T8 und T9. Im ersteren Fall wird die Leistungsaufnahme des Differenzverstärkers etwas erhöht, im letzteren Fall etwas erniedrigt.

Es liegt weiterhin im Rahmen der Erfindung, die beiden Kanaltypen der verwendeten Feldeffekttransistoren jeweils gegeneinander auszutauschen und gleichzeitig die Polaritäten der zugeführten Spannungen durch die entgegengesetzten zu ersetzen. Dabei sind dann auch die Spannungswerte von U_{A1} und U_{G1} miteinander zu vertauschen, was in Fig. 2 bedeutet, daß die Spannungsverläufe u4 und u5 an die Stelle der Spannungsverläufe u8 und u9 treten und umgekehrt. In diesem Fall setzt PU einen niedrigen Eingangspegel U_{G1}, d.h. den Gleichstromanteil des einer Gatevorspannung überlagerten Eingangssignals u1, auf einen höheren Ausgangspegel U_{A1} um.

## Patentansprüche

1. Differenzverstärker mit zwei parallelen, zwischen einem Schaltungsknoten (1) und einem ersten Versorgungsspannungsanschluß (2) liegenden Schaltungszweigen, die jeweils ein Lastelement (L1, L2) und einen Feldeffekttransistor (T1, T2) eines Kanaltyps enthalten, mit einem weiteren, zwischen dem Schaltungsknoten (1) und einem zweiten Versorgungsspannungsanschluß (3) liegenden Schaltungszweig, der eine Stromquelle (T3) aufweist, wobei sich der von dieser gelieferte Ruhestrom auf beide parallelen Schaltungszweige aufteilt, und mit zwei der Stromquelle (T3) parallel geschalteten, als steuerbare Stromquellen dienenden, weiteren Feldeffekttransistoren (T8, T9) desselben Kanaltyps, die den Ruhestrom verstärkende Zusatzströme liefern, wobei die Gateanschlüsse (4, 5) der Feldeffekttransistoren (T2, T1) mit einem Eingangssignal belegt sind und das Ausgangssignal an den Verbindungspunkten zwischen den Lastelementen (L1, L2) und den Feldeffekttransistoren (T1, T2) abgreifbar ist, **dadurch gekennzeichnet,** daß die Feldeffekttransistoren (T1, T2) und die weiteren Feldeffekttransistoren (T8, T9) dem n-Kanaltyp angehören und daß eine eingangsseitig mit den Gateanschlüssen (4, 5) der Feldeffekttransistoren (T2, T1) verbundene, den Gleichstromanteil des Eingangssignals auf einen niedrigeren Ausgangspegel umsetzende Schaltung (PU) vorgesehen ist, die ausgangsseitig mit den Gateanschlüssen der weiteren Feldeffekttransistoren (T8, T9) beschaltet ist.

2. Differenzverstärker mit zwei parallelen, zwischen einem Schaltungsknoten (1) und einem ersten Versorgungsspannungsanschluß (2) liegenden Schaltungszweigen, die jeweils ein Lastelement (L1, L2) und einen Feldeffekttransistor (T1, T2) eines Kanaltyps enthalten, mit einem weiteren, zwischen dem Schaltungsknoten (1) und einem zweiten Versorgungsspannungsanschluß (3) liegenden Schaltungszweig, der eine Stromquelle (T3) aufweist, wobei sich der von dieser gelieferte Ruhestrom auf beide parallelen Schaltungszweige aufteilt, und mit zwei der Stromquelle (T3) parallel geschalteten, als steuerbare Stromquellen dienenden, weiteren Feldeffekttransistoren (T8, T9) desselben Kanaltyps, die den Ruhestrom verstärkende Zusatzströme liefern, wobei die Gateanschlüsse (4, 5) der Feldeffekttransistoren (T2, T1) mit einem Eingangssignal belegt sind und das Ausgangssignal an den Verbindungspunkten zwischen den Lastelementen (L1, L2) und den Feldeffekttransistoren (T1, T2) abgreifbar ist, **dadurch gekennzeichnet,** daß die Feldeffekttransistoren (T1, T2) und die weiteren Feldeffekttransistoren (T8, T9) dem p-Kanaltyp angehören und daß eine eingangsseitig mit den Gateanschlüssen (4, 5) der Feldeffekttransistoren (T2, T1) verbundene, den Gleichstromanteil des Eingangssignals auf einen höheren Ausgangspegel umsetzende Schaltung (PU) vorgesehen ist, die ausgangsseitig mit den Gateanschlüssen der weiteren Feldeffekttransistoren (T8, T9) beschaltet ist.

3. Differenzverstärker nach Anspruch 1 oder 2, **dadurch gekennzeichnet,** daß die den Gleichstromanteil des Eingangssignals umsetzende Schaltung (PU) aus einer Differenzverstärkerstufe besteht, die zwei zwischen einem weiteren Schaltungsknoten (10) und dem zweiten Versorgungsspannungsanschluß (11) liegende Stromzweige enthält, von denen jeder eine Reihenschaltung zweier Feldeffekttransistoren unterschiedlicher Kanaltypen (T10, T11, T12, T13) aufweist, daß der weitere Schaltungsknoten (10) über einen Stromquellentransistor (T14) des einen Kanaltyps mit dem ersten Versorgungsspannungsanschluß (12) verbunden ist, daß die Gateanschlüsse der dem Kanaltyp des Stromquellentransistors (T14) entsprechenden Feldeffekttransistoren (T10, T12) der Stromzweige die Schaltungseingänge (6, 7) bilden, daß die Verbindungspunkte zwischen den letzteren Feldeffekttransistoren (T10, T12) und den anderen beiden Feldeffekttransistoren (T11, T13) der Stromzweige die Schaltungsausgänge (8, 9) darstellen und daß diese anderen beiden Feldeffekttransistoren (T11, T13) im Triodengebiet arbeiten, während der Stromquellentransistor (T14) im Sättigungsgebiet betrieben wird.

4. Differenzverstärker nach Anspruch 3, **dadurch gekennzeichnet,** daß zwei die beiden Versorgungsspannungsanschlüsse (11, 12) miteinander verbindende, zusätzliche Stromzweige vorgesehen sind, die jeweils einen dem Kanaltyp des Stromquellentransistors (T14) entsprechenden, ersten Feldeffekttransistor (T15, T17) in Serie zu einem den anderen Kanaltyp aufweisenden, zweiten Feldeffekttransistor (T16, T18) enthalten, daß der Gateanschluß des ersten Feldeffekttransistors (T15) des ersten zusätzlichen Stromzweigs mit dem zweiten Versorgungsspannungsanschluß (11) verbunden ist, daß der Gateanschluß des zweiten Feldeffekttransistors (T16) desselben Stromzweigs mit seinem Drainanschluß und mit dem Gateanschluß des zweiten Feldeffekttransistors (T18) des anderen zusätzlichen Stromzweigs beschaltet ist, daß der Gateanschluß des ersten Feldeffekttransistors (T17) des zweiten zusätzlichen Stromzweigs mit seinem Drainanschluß beschaltet ist und daß der Gateanschluß des Stromquellentransistors (T14) mit dem Gateanschluß des ersten Feldeffekttransistors (T17) des zweiten zusätzlichen Stromzweiges und die Gateanschlüsse der anderen beiden Feldeffekttransistoren (T11, T13) der Stromzweige mit dem Gateanschluß des zweiten Feldeffekttransistors (T18) des zweiten zusätzlichen Stromzweiges verbunden sind.

5. Differenzverstärker nach Anspruch 3, **dadurch gekennzeichnet,** daß die Ausgänge (8, 9) der den Gleichstromanteil des Eingangssignals umsetzenden Schaltung (PU) über zwei zusätzliche Schaltungen (INV2, INV1) mit den Gateanschlüssen der weiteren Feldeffekttransistoren (T8, T9) verbunden sind, wobei jede der zusätzlichen Schaltungen einen Inverter (T23, T24, T19, T20) aufweist, dessen Ausgang an den Gateanschluß eines nachgeschalteten Feldeffekttransistors (T25, T21) gelegt ist, über den die Versorgungsspannung an die Gateanschlüsse der weiteren Feldeffekttransistoren (T8, T9) durchschaltbar ist.

## Claims

1. Differential amplifier having two parallel circuit branches which are located between a circuit node (1) and a first supply voltage connection (2) and each contain a load element (L1, L2) and a field-effect transistor (T1, T2) of one conductance type, having a further circuit branch, which is located between the circuit node (1) and a second supply voltage connection (3) and has a power source (T3), the quiescent current supplied from the latter being split between two parallel circuit branches, and having two further field-effect transistors (T8, T9) which are connected in parallel with the power source (T3), are used as controllable power sources, are of the same conductance type and supply additional currents which amplify the quiescent current, the gate connections (4, 5) of the field-effect transistors (T2, T1) having an input signal applied to them, and it being possible to pick off the output signal at the connecting points between the load elements (L1, L2) and the field-effect transistors (T1, T2), characterised in that the field-effect transistors (T1, T2) and the further field-effect transistors (T8, T9) belong to the n-conductance type, and in that a circuit (PU) is provided which is connected on the input side to the gate connections (4, 5) of the field-effect transistors (T2, T1), converts the DC current component of the input signal to a lower output level, and is connected on the output side to the gate connections of the further field-effect transistors (T8, T9).

2. Differential amplifier having two parallel circuit branches which are located between a circuit node (1) and a first supply voltage connection (2) and each contain a load element (L1, L2) and a field-effect transistor (T1, T2) of one conductance type, having a further circuit branch, which is located between the circuit node (1) and a second supply voltage connection (3) and has a power source (T3), the quiescent current supplied from the latter being split between two parallel circuit branches, and having two further field-effect transistors (T8, T9) which are connected in parallel with the power source (T3), are used as controllable power sources, are of the same conductance type and supply additional currents which amplify the quiescent current, the gate connections (4, 5) of the field-effect transistors (T2, T1) having an input signal applied to them, and it being possible to pick off the output signal at the connecting points between the load elements (L1, L2) and the field-effect transistors (T1, T2), characterised in that the field-effect transistors (T1, T2) and the further field-effect transistors (T8, T9) belong to the p-conductance type, and in that a circuit (PU) is provided which is connected on the input side to the gate connections (4, 5) of the field-effect transistors (T2, T1), converts the DC current component of the input signal to a higher output level, and is connected on the output side to the gate connections of the further field-effect transistors (T8, T9).

3. Differential amplifier according to Claim 1 or 2, characterised in that the circuit (PU) which converts the DC component of the input signal comprises a differential amplifier stage which contains two current branches which are located between a further circuit node (10) and the second supply voltage connection (11), each of which has a series circuit of two field-effect transistors of different conductance types (T10, T11, T12, T13), in that the further circuit node (10) is connected via a power source transistor (T14) of the one conductance type to the first supply voltage connection (12), in that the gate connections of the field-effect transistors (T10, T12), which correspond to the conductance type of the power source transistor (T14), of the current branches form the circuit input (6, 7), in that the connecting points between the last-mentioned field-effect transistors (T10, T12) and the other two field-effect transistors (T11, T13) of the current branches represent the circuit outputs (8, 9), and that these other two field-effect transistors (T11, T13) operate in the triode region, while the power source transistor (T14) is operated in the saturation region.

4. Differential amplifier according to Claim 3, characterised in that two additional current branches are provided which connect two supply voltage connections (11, 12) to one another and each contain a first field-effect transistor (T15, T17), which corresponds to the conductance type of the power source transistor (T14), in series with a second field-effect transistor (T16, T18), which has the other conductance type, in that the gate connection of the first field-effect transistor (T15) of the first additional current branch is connected to the second supply voltage connection (11), in that the gate connection of the second field-effect transistor (T16) of the same current branch is connected to its drain connection and to the gate connection of the second field-effect transistor (T18) of the other additional current branch, in that the gate connection of the first field-effect transistor (T17) of the second additional current branch is connected to its drain connection, and in that the gate connection of the power source transistor (T14) is connected to the gate connection of the first field-effect transistor (T17) of the second additional current branch, and the gate connections of the other two field-effect transistors (T11, T13) of the current branches are connected to the gate connection of the second field-effect transistor (T18) of the second additional current branch.

5. Differential amplifier according to Claim 3, characterised in that the outputs (8, 9) of the circuit (PU) which converts the DC component of the input signal are connected via two additional circuits (INV2, INV1) to the gate connections of the further field-effect transistors (T8, T9), each of the additional circuits having an invertor (T23, T24, T19, T20) whose output is connected to the gate connection of a downstream-connected field-effect transistor (T25, T21), via which the supply voltage can be connected through to the gate connections of the further field-effect transistors (T8, T9).

## Revendications

1. Amplificateur différentiel comportant deux branches de circuit parallèles, qui sont disposées entre un noeud (1) du circuit et une première borne de tension d'alimentation (2) et qui comporte chacune un élément de charge (L1,L2) et un transistor à effet de champ (T1,T2) possédant un premier type de canal, et comportant une autre branche de circuit, qui est raccordée à une seconde borne de tension d'alimentation (3) et comporte une source de tension (T3), qui délivre un courant de repos réparti entre les deux branches parallèles du circuit, et comportant deux autres transistors à effet de champ (T8,T9) possédant le même type de canal, qui sont branchés en parallèle avec la source de courant (T3), qui sont utilisés en tant que sources de courant commandables et qui délivrent les courants supplémentaires amplifiant le courant de repos, les bornes de grille (4,5) des transistors à effet de champ (T2,T1) étant occupées par un signal d'entrée, tandis que le signal de sortie peut être prélevé au niveau des points de jonction entre les éléments de charge (L1,L2) et les transistors à effet de champ (T1,T2), caractérisé par le fait que les transistors à effet de champ (T1,T2) et les autres transistors à effet de champ (T8,T9) sont du type à canal n, et qu'il est prévu un circuit (PU), qui est raccordé côté entrée aux bornes de grille (4,5) des transistors à effet de champ (T2,T1), qui convertit la composante de courant continu du signal d'entrée en un niveau de tension inférieur et qui est raccordé, côté sortie, aux bornes de grille des autres transistors à effet de champ (T8,T9).

2. Amplificateur différentiel comportant deux branches de circuit parallèles, qui sont disposées entre un noeud (1) du circuit et une première borne de tension d'alimentation (2) et comportent chacune un élément de charge (L1,L2) et un transistor à effet de champ (T1,T2) possédant un premier type de canal, et comportant une autre branche de circuit, qui est raccordée à une seconde borne de tension d'alimentation (3) et qui comporte une source de tension (T3), qui délivre un courant de repos réparti entre les deux branches parallèles du circuit, et comportant deux autres transistors à effet de champ (T8,T9) possédant le même type de canal, qui sont branchés en parallèle avec la source de courant (T3), qui sont utilisés en tant que sources de courant commandables et qui délivrent les courants supplémentaires amplifiant le courant de repos, les bornes de grille (4,5) des transistors à effet de champ (T2,T1) étant occupées par un signal d'entrée, tandis que le signal de sortie peut être prélevé au niveau des points de jonction entre les éléments de charge (L1,L2) et les transistors à effet de champ (T1,T2), caractérisé par le fait que les transistors à effet de champ (T1,T2) et les autres transistors à effet de champ (T8,T9) sont du type à canal p et qu'il est prévu un circuit (PU), qui est raccordé côté entrée aux bornes de grille (4,5) du transistor à effet de champ (T2,T1), qui convertit la composante de courant continu du signal d'entrée en l'amenant à un niveau de sortie supérieur et qui est raccordé côté sortie aux bornes de grille des autres transistors à effet de champ (T8,T9).

3. Amplificateur différentiel suivant la revendication 1 ou 2, caractérisé par le fait que le circuit (PU), qui commute la composante de courant continu du signal d'entrée, est constitué par un étage amplificateur différentiel, qui comporte des branches de circulation du courant, qui sont situés entre un autre noeud (10) du circuit et la seconde borne de tension d'alimentation (11) et dont chacun possède un montage série formé de deux transistors à effet de champ ayant des types de canaux différents (T10,T11,T12,T13), que l'autre noeud (10) du circuit est raccordé, par l'intermédiaire d'un transistor formant source de courant (T14) possédant le premier type de canal, à la première borne de tension d'alimentation (12), que les bornes de grille des transistors à effet de champ (T10,T12), qui correspondent au type de canal du transistor formant source de courant (T14), des branches de circulation du courant, constituent les entrées (6,7) du circuit, que des points de jonction entre les derniers transistors à effet de champ (T10,T12) et les autres transistors à effet de champ (T11,T13) des branches de circulation du courant représentent les sorties (6,8,9) du circuit, et que ces deux autres transistors à effet de champ (T11,T13) fonctionnent dans la gamme triode, tandis que le transistor formant source de courant (T14) fonctionne à la saturation.

4. Amplificateur différentiel suivant la revendication 3, caractérisé par le fait qu'il est prévu deux branches supplémentaires de circulation du courant, qui relient entre elles les deux bornes de tension d'alimentation (11,12) et qui comportent chacune un premier transistor à effet de champ (T15,T17), qui correspond au type de canal du transistor formant source de courant (T14), en série avec un second transistor à effet de champ (T16,T18), qui possède l'autre type de canal, que la borne de grille du premier transistor à effet de champ (T14) de la première branche supplémentaire de circulation du courant est raccordée à la seconde borne de tension d'alimentation (11), que la borne de grille du second transistor à effet de champ (T16) de cette même branche de circulation du courant est raccordée à sa borne de drain et à la borne de grille du second transistor à effet de champ (T18) de l'autre branche supplémentaire de circulation du courant, que la borne de grille du premier transistor à effet de champ (T17) de la seconde branche supplémentaire de circulation du courant est raccordée à sa borne de drain et que la borne de grille du transistor formant source de courant (T14) est raccordée à la borne de grille du premier transistor à effet de champ (T17) de la seconde branche supplémentaire de courant et que les bornes de grille des deux autres transistors à effet de champ (T11 et T13) des branches de circulation du courant sont raccordées à la borne de grille du second transistor à effet de champ (T18) de l'autre branche supplémentaire de circulation du courant.

5. Amplificateur différentiel suivant la revendication 3, caractérisé par le fait que les sorties (8,9) du circuit (PU), qui convertit la composante de courant continu du signal d'entrée, sont raccordées, par l'intermédiaire de deux circuits supplémentaires (INV2, INV1), aux bornes de grille des autres transistors à effet de champ (T8,T9), auquel cas chacun des circuits supplémentaires possède un inverseur (T23,T24,T19,T20), dont la sortie est raccordée à la borne de grille d'un transistor à effet de champ (T25,T21) branché en aval et au moyen duquel la tension d'alimentation peut être appliquée aux bornes de grille des autres transistors à effet de champ (T8,T9).
